# EUROPEAN PATENT APPLICATION

(11) **EP 4 435 657 A1**
(43) Date of publication of application: **25.09.2024**
(21) Application number: 23163923.8
(22) Date of filing: 24.03.2023
(51) Int. Cl.: G06F 30/13, G06K 19/00, H05B 47/10, H05B 47/19

(54) **INTERACTIVE GROUND PLAN FOR A LIGHTING SYSTEM**

(71) Applicant: Tridonic Portugal, Unipessoal Lda, 4400-676 Villa Nova de Gaia (PT)
(72) Inventor: Severinkangas, Kari, 6850 Dornbirn (AT); Silva, Carlos, 6850 Dornbirn (AT); Azevedo, João, 6850 Dornbirn (AT); Sousa, Antonio, 6850 Dornbirn (AT); Filipe, Jorge, 6850 Dornbirn (AT)
(74) Representative: Beder, Jens

(57) **Abstract**

The present invention relates to a system for providing information on a device (4..6) of a lighting system. The system comprises a processor configured to generate a machine-readable code (9) for a ground plan (8) of a space, in which the lighting system is or will be installed, wherein the machine-readable code (9) comprises the device information or access information to access the device information, and position the machine-readable code (9) in the ground plan (8).

## Description

The invention relates to a system and method for providing information on devices of a lighting system and a commissioning device for commissioning the devices using the device information.

Commissioning, which is the process of associating a physical position of an installed building technology device (e.g. a luminaire, sensor, window shade actuator, or controller) with a logical (e.g. bus or network) address, is an essential step during the installation and setup of a lighting system. During the commissioning process, dedicated software or dedicated commissioning tools are used to assign an address and/or a geographical position to building technology devices. Afterwards, a grouping of the building technology devices (DALI group) and/or an association with a work flow definition, e.g. a scene definition, is performed.

At least the installation of the devices is carried out based on a ground/floor plan of a space/building, in which the lighting system is to be installed. In the plan, usually created by an architect, symbols are inserted to indicate the position of installation or even the type of device. However, this information is often inaccurate and insufficient for installation or commissioning.

It is an object of the present invention to provide an apparatus and a method, which reduce the above problems. In particular, an object of the present invention is to provide a system and a method that can provide a variety of device information with low effort and costs and to provide a commissioning device that can easily acquire the device information.

This object is achieved by the system, the commissioning device and the method according to the enclosed independent claims. Advantageous features of the present invention are defined in the corresponding subclaims.

According to the present invention, the system is configured to provide device information of a device of a lighting system and comprises a processor that is configured to generate a machine-readable code for a ground plan of a space, in which the lighting system is or will be installed, and that is configured to position the machine-readable code in the ground plan. The machine-readable code comprises the device information or access information to access the device information.

In this way, a variety of information can be provided for each device of the lighting system or at least a part of the devices. Preferably, the device information includes at least one of device type, device name, device ID, device address, operating parameters, wiring information, installation position, installation orientation, operating instructions, product specifications, safety instructions, control information and connection information required by a commissioning device to establish a wireless connection between the commissioning device and the device of the lighting system.

The processor can be configured to position the machine-readable code in a code area (symbol legend area) of the ground plan. Alternatively, the processor can be configured to position the machine-readable code in the ground plan at a position that corresponds to a location of the space where the device is or will be installed or is configured to position the machine-readable code in the ground plan in an area around a marker that indicates the position.

The machine-readable code can be inserted into the plan in addition to the symbol/icon described above or instead of it. Preferably, the processor is configured to embed the machine-readable code in a device icon.

The plan can be printed on paper, displayed and/or output in electronic form (file). The ground plan can be a computer-aided design (CAD) comprising at last one layer for the lighting system, wherein the processor is configured to position the machine-readable code in the at last one layer for the lighting system. In this way, the machine-readable code can be hidden by deactivating the layer.

The machine-readable code can be a visual code, such as a dot pattern detectable by an (infrared) reading pen, wherein the ground plan can be a digital paper. Alternatively, the machine-readable code can be one-dimensional barcode, two-dimensional barcode, matrix barcode or a QR code.

The machine-readable code can be generated from a random number or (virtual) ID, wherein the device information is assigned to the random number or the (virtual) ID e.g. by a user in a table, so that the random number/ID decoded from the machine-readable code acts as access information. Alternatively, the access information can contain at least one Uniform Resource Locator, wherein the processor is configured to generate an HTML file that is associated to the Uniform Resource Locator and that contains the device information.

With the access information, at least part of the device information can be collected/stored after the machine-readable code is generated and positioned in the ground plan. In particular, device information can be acquired from the (already installed) device. For this, the system can further comprise a commissioning device configured to acquire, from the device of the lighting system, the device ID, the device address (e.g., DALI or network address) and/or the connection information (e.g., Bluetooth-PIN and/or a media access control address), to read the machine-readable code from the ground plan and to assign the device ID, the device address and/or the connection information to the machine-readable code to generate or complete the device information. Alternatively or in addition, the device ID, the device address and/or the connection information can be input by a user via a graphical user interface of the mobile commissioning device.

The term "commissioning" is used generally to refer both to the programming of devices for dedicated behavior and to the programming for locating known devices in a community of networked devices.

According to the present invention, the commissioning device for commissioning a device of a lighting system comprises at least one sensor configured to read a machine-readable code from a ground plan, wherein the machine-readable code comprises device information of the device or access information to access the device information, and a processor configured to decode the machine-readable code to obtain device information.

The obtained device information can comprise at least operating parameters and/or control information and the commissioning device is configured to transmit the operating parameters and/or the control information to the device of the lighting system.

Traditional commissioning methods consist of two phases. The first phase involves identifying a connected device like a luminaire, sensor, actuator or controller to create a relation between a digital representation (DALI address) and the physical location where the device is located in a building relative to the ground plan. The second phase (configuration) involves defining behavior between the input and output devices, such as defining a group of lights to turn on/off based on a dedicated wall switch or the like, or adopt brightness and color temperature depending on time of day or ambient lighting detected from sensors.

To facilitate the determination of the physical location, the mobile commissioning device can comprise a graphical user interface configured to receive a user input to perform a locating operation of visual locating a device of the lighting system, wherein the at least one sensor is configured to read a machine-readable code from the ground plan in the locating operation and the processor is configured to decode the machine-readable code to obtain device information, to determine a device address from the device information and to transmit, to a device assigned to the device address, a command to control the device to output a signal for visually locating the device by a user. In this way, the user can, for example, easily identify a luminaire marked in the ground plan on site and, if necessary, correct its position in the ground plan or mark its exact position in an electronic ground plan.

In addition or alternatively, the device information can comprise at least connection information required by the commissioning device to establish a wireless connection between the commissioning device and the device of the lighting system and the commissioning device is configured to establish the wireless connection based on the connection information.

In the second phase (configuration), a DALI group can be easily defined by scanning the respective codes from a ground plan. For this, the mobile commissioning device can comprise a graphical user interface configured to receive a user input to perform a configuration operation of defining members of a DALI group, wherein the at least one sensor is configured to read different machine-readable codes from the ground plan in the configuration operation and the processor is configured to decode the different machine-readable codes to obtain the device information and is configured to determine devices of the DALI group based on the device information.

The obtained device information can comprise at least operating parameters and/or control information, wherein the commissioning device is configured to transmit the operating parameters and/or the control information to the device of the lighting system.

In addition or alternatively, the commissioning device can be configured to acquire and display the device information. In particular, the at least one sensor can be a camera configured to generate an image of at least a part of the ground plan, wherein the processor is configured to decode machine-readable codes contained in the image to obtain the device information and is configured to replace, in the image, the machine-readable codes by the respective device information and the mobile commissioning device comprises a display configured to display the image containing the device information. Preferably, the user can determine which device information (device type, device name, device ID, device address ...) is to be displayed.

According to the present invention, the method for providing device information on a device of a lighting system comprises the steps of:
- generating a machine-readable code for a ground plan of a space, in which the lighting system is or will be installed, wherein the machine-readable code comprises the device information or access information to access the device information, and
- positioning the machine-readable code in the ground plan.

Embodiments of the invention are discussed in detail with reference to the enclosed figures, in which
FIG. 1 shows a block diagram of a system according to an embodiment of the present invention,
FIG. 2 shows a ground plan with QR codes inserted according to an embodiment of the present invention,
FIG. 3 shows a QR code embedded in an icon of a luminaire according to an embodiment of the present invention, and
FIG. 4 shows a QR code embedded in an icon of switch according to an embodiment of the present invention.

In the figures, same reference numbers denote same or equivalent structures. The explanation of structures with same reference numbers in different figures is avoided where deemed possible for sake of conciseness.

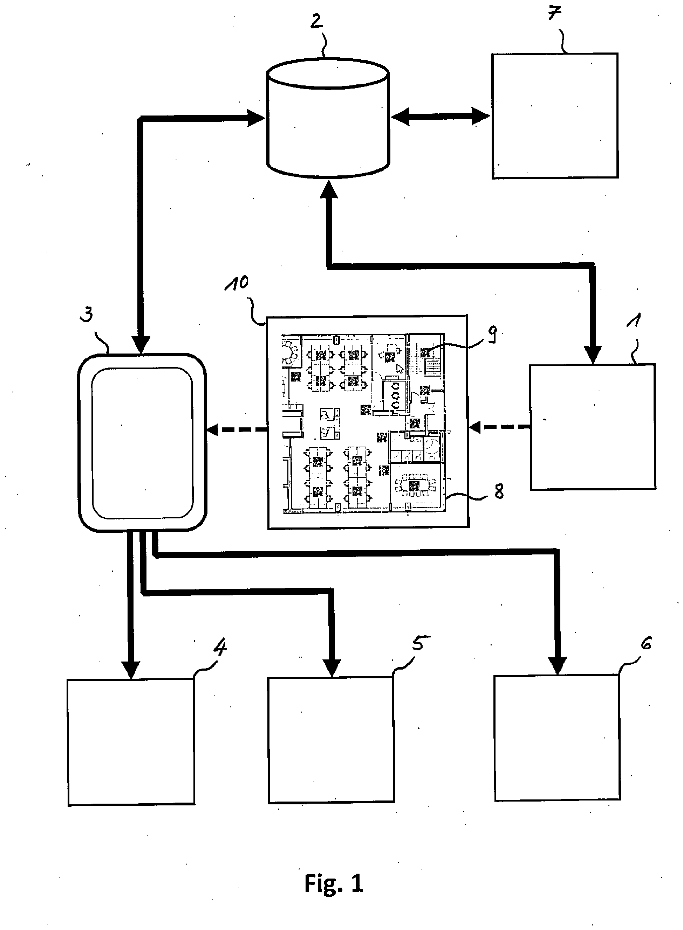

FIG. 1 shows a system for providing device information according to an embodiment of the present invention. The system shown in FIG. 1 comprises a user terminal 1 (data processing device), a database (server) 2 and a mobile commissioning device 3 configured to communicate with installed building technology devices 4..6 (e.g. luminaire, sensor, controller) of a lighting system via a Bluetooth connection, NFC or DALI-bus to identify and/or configure the devices 4..6.

In the case of a new building, renovation or extension, the electrical installation, in particular the lighting system, is planned and an installation plan is drawn up for the installer. The installation plan is usually a floor/ground plan in which symbols/icons of the devices 4..6 are inserted to indicate the position of installation or even the device type. According to the present invention, instead of the symbols or in addition to the symbols, machine-readable codes generated/encoded from device information or from access information to access the device information are inserted in the ground plan.

In FIG. 1, the ground plan is created by an architect using a CAD system 7 and is stored in the database 2 as bitmap or CAD file. The database 2 also stores a product catalog of available building technology devices 4..6, which contains device information. The user terminal 1 (data processing device) reads at least the ground plan from the database 2, determines position of each device (e.g. luminaire, sensor, switch) to be installed, generates a unique QR code (or another machine-readable code) for each device, inserts the QR codes in the ground plan at the determined positions and prints the ground plan 8 with the QR codes 9 inserted on a piece of paper 10. This can be done manually or in an automated manner. In particular, a ground plan 8 with device symbols/icons inserted can be read from the database 2, wherein the user terminal 1 automatically generates a unique QR code for each symbol/icon and automatically replaces the symbols/icons by the QR codes.

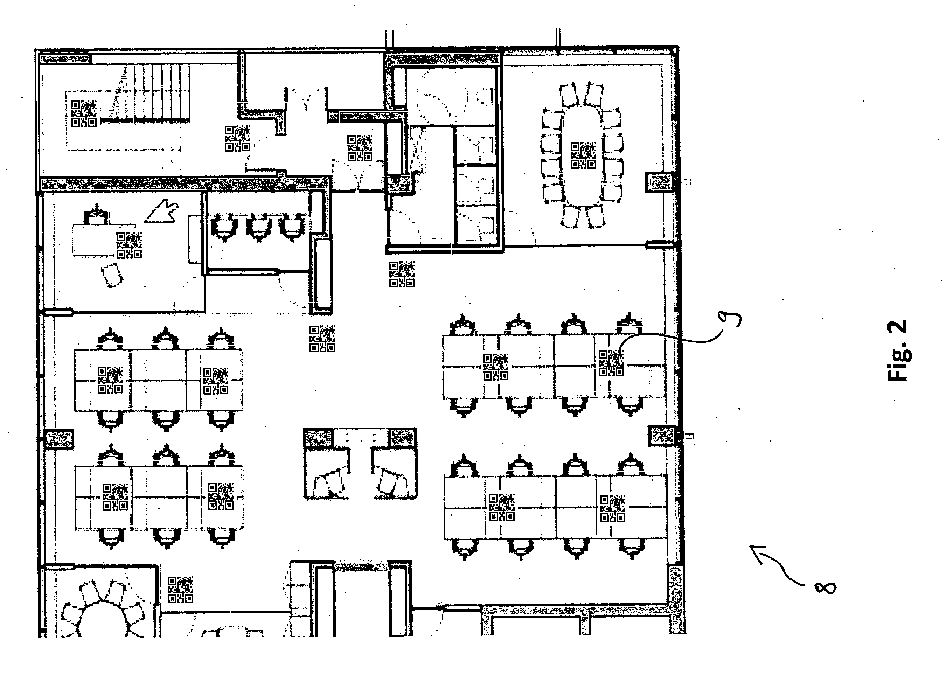

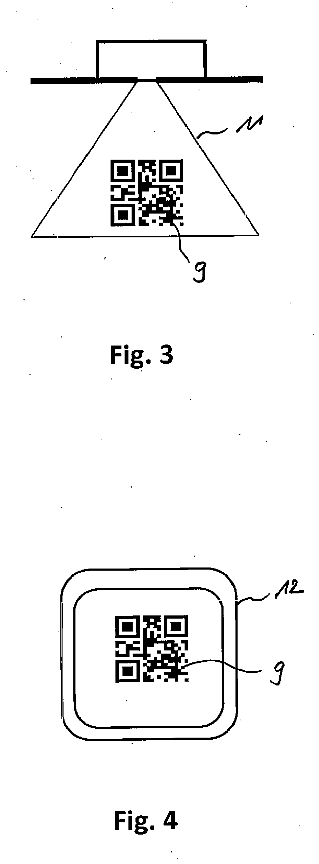

FIG. 2 shows the ground plan 8 with the QR codes 9 inserted. Alternatively, QR codes 9 can be embedded in the symbols/icons. FIG. 3 shows a QR code 9 embedded in an icon 11 of a LED spot and FIG. 4 shows a QR code 9 embedded in an icon 12 of switch.

The QR code can be generated from a random number or the respective device ID, if known at that time, so that, when the QR code is read/decoded, the random number or device ID is obtained. Before or after the ground plan is printed, the user terminal 1 determines and assigns device information to each random number/device ID and stores, for each of devices 4..6, the random number/device ID and the device information assigned to the respective random number/device ID in the database 2 in the form of a table or a data record. In this way, the random number/device ID serves as access information to access the respective device information in the table or record. Alternatively, the QR code can contain at least a part of the device information, e.g., device name, type and/or model.

The device information can be device type/model (e.g., LED spot, LED panel, LED panel dimmable), device name, device/DALI address, operating parameters set for the device (e.g., max/min dim level, color temperature, fade times, maximum current), wiring information, installation position, installation orientation, operating instructions, product specifications, safety instructions, control information and/or connection information required by the commissioning device 3 to establish a wireless connection between the commissioning device 3 and the device. The user terminal 1 and/or the commissioning device 3 can update the stored table/data record.

The commissioning device 3 is a mobile device, such as a tablet, which comprises a camera (not shown) to capture a QR code 9 in the ground plan 8, a processor to decode/read QR code 9 to obtain the access information (random number/device ID) and to request/read the device information from the database 2 assigned to the random number/device ID. The device information containing, for example, information on the device type, wiring and installation position/coordinates (e.g., distance between the device and the ceiling) can be displayed so that the user can select the correct device 4..6 and mount it according to the instructions. In addition or alternatively, the device information contains control information and operating parameters for the device 4..6 and the commissioning device 3 connects and configures the device 4..6 based on the control information and the operating parameters. Alternatively, the user can determine control information and operating parameters and store/update the control information and the operating parameters in the database 2.

To automatically retrieve the device information by the commissioning device 3, the access information can contain at least one Uniform Resource Locator, wherein an HTML file that is associated to the Uniform Resource Locator and that contains the device information is generated.

The user terminal 1 shown in FIG. 1 generates a unique QR code for each device or symbol/icon. Alternatively, the same QR code can be assigned to all devices 4..6 (icons) of a predetermined group/type. The ground plan 8 with the inserted QR codes 9 can stored in the database 2.

## Claims

1. A system for providing device information on a device (4..6) of a lighting system, comprising a processor configured to
generate a machine-readable code (9) for a ground plan (8) of a space, in which the lighting system is or will be installed, wherein the machine-readable code (9) comprises the device information or access information to access the device information, and
position the machine-readable code (9) in the ground plan (8).

2. The system according to claim 1, wherein
the processor (1) is configured to position the machine-readable code (9) in the ground plan (8) at a position that corresponds to a location of the space where the device is or will be installed or is configured to position the machine-readable code (9) in the ground plan (8) in an area around a marker that indicates the position.

3. The system according to claim 1 or 2, wherein
the processor (1) is configured to embed the machine-readable code (9) in a device icon (11, 12).

4. The system according to any one of the preceding claims, wherein
the ground plan (8) is a computer-aided design comprising at last one layer for the lighting system and the processor (1) is configured to position the machine-readable code (9) in the at last one layer for the lighting system.

5. The system according to any one of the preceding claims, wherein
the machine-readable code (9) is a visual code and/or a dot pattern, a one-dimensional barcode, a two-dimensional barcode, a matrix barcode or a QR code.

6. The system according to any one of the preceding claims, wherein
the access information contains at least one Uniform Resource Locator; and
the processor (1) is configured to generate an HTML file that is associated to the Uniform Resource Locator and that contains the device information.

7. The system according to any one of the preceding claims, wherein
the device information includes at least one of: device type, device name, device ID, device address, operating parameters, wiring information, installation position, installation orientation, operating instructions, product specifications, safety instructions, control information and connection information required by a commissioning device to establish a wireless connection between the commissioning device and the device of the lighting system.

8. The system according to claim 7, further comprising
a commissioning device configured to acquire the device ID, the device address and/or the connection information from the device of the lighting system, to read the machine-readable code (9) from the ground plan (8) and to assign the device ID, the device address and/or the connection information to the machine-readable code (9) to generate or complete the device information.

9. A commissioning device for commissioning a device of a lighting system, comprising
at least one sensor configured to read a machine-readable code (9) from a ground plan (8), wherein the machine-readable code (9) comprises device information of the device or access information to access the device information; and
a processor configured to decode the machine-readable code (9) to obtain device information.

10. The commissioning device according to claim 9, wherein
the obtained device information comprises at least operating parameters and/or control information and the commissioning device (3) is configured to transmit the operating parameters and/or the control information to the device (4..6) of the lighting system.

11. The commissioning device according to claim 10, wherein
the mobile commissioning device comprises a graphical user interface configured to receive a user input to perform a locating operation of visual locating a device (4..6) of the lighting system;
the at least one sensor is configured to read a machine-readable code (9) from the ground plan (8) in the locating operation; and
the processor is configured to decode the machine-readable code (9) to obtain device information, to determine a device address from the device information and to transmit, to a device (4..6) assigned to the device address, a command to control the device (4..6) to output a signal for visually locating the device by a user.

12. The commissioning device according to any one of claims 9 to 11, wherein
the device information comprises at least connection information required by the commissioning device (3) to establish a wireless connection between the commissioning device (3) and the device (4..6) of the lighting system and the commissioning device is configured to establish the wireless connection based on the connection information.

13. The commissioning device according to any one of claims 9 to 12, wherein
the mobile commissioning device (3) comprises a graphical user interface configured to receive a user input to perform a configuration operation of defining members of a DALI group;
the at least one sensor is configured to read different machine-readable codes (9) from the ground plan (8) in the configuration operation; and
the processor is configured to decode the different machine-readable codes (9) to obtain the device information and is configured to determine devices (4..6) of the DALI group based on the device information.

14. The commissioning device according to any one of claims 9 to 13, wherein
the at least one sensor is a camera configured to generate an image of at least a part of the ground plan (8);
the processor is configured to decode machine-readable codes (9) contained in the image to obtain the device information and is configured to replace, in the image, the machine-readable codes (9) by the respective device information; and
the mobile commissioning device (3) comprises a display configured to display the image containing the device information.

15. A method for providing device information on a device (4..6) of a lighting system, comprising the steps of:
generating a machine-readable code (9) for a ground plan (8) of a space, in which the lighting system is or will be installed, wherein the machine-readable code (9) comprises the device information or access information to access the device information, and
positioning the machine-readable code (9) in the ground plan (8).
